# EUROPÄISCHE PATENTSCHRIFT

(11) **EP 1 687 859 B1**
(45) Veröffentlichungstag und Bekanntmachung des Hinweises auf die Patenterteilung: **07.08.2013**
(21) Anmeldenummer: 04803246.0
(22) Anmeldetag: 24.11.2004
(51) Int. Cl.: H01L 51/00, H01L 51/50

(54) **ORGANISCHES ELEKTROLUMINESZENZELEMENT**
ORGANIC ELECTROLUMINESCENT ELEMENT
ELEMENT ORGANIQUE ELECTROLUMINESCENT

(30) Priorität: 25.11.2003 DE 10355381; 10.02.2004 DE 102004006622; 01.04.2004 DE 102004015933
(43) Veröffentlichungstag der Anmeldung: 09.08.2006
(73) Patentinhaber: Merck Patent GmbH, 64293 Darmstadt (DE)
(72) Erfinder: GERHARD, Anja, 97209 Veitshöchheim (DE); VESTWEBER, Horst, 34830 Gilserberg-Winterscheid (DE); STÖSSEL, Philipp, 60487 Frankfurt am Main (DE)
(86) Internationale Anmeldenummer: PCT/EP2004/013315
(87) Internationale Veröffentlichungsnummer: WO 2005/053051

(56) Entgegenhaltungen:
- EP-B1- 2 126 996
- WO-A-03/001569
- WO-A-03/072681
- WO-A-2004/016709
- US-A1- 2002 028 349
- US-A1- 2003 096 138
- LI H ET AL: "ORGANIC LIGHT-EMITTING DEVICES BASED ON AROMATIC POLYIMIDE DOPED BY ELECTROPHOSPHORESCENT MATERIAL FAC TRIS(2-PHENYLPYRIDINE) IRIDIUM" SEMICONDUCTOR SCIENCE AND TECHNOLOGY, INSTITUTE OF PHYSICS. LONDON, GB, Bd. 18, Nr. 4, April 2003 (2003-04), Seiten 278-283, XP001169967 ISSN: 0268-1242
- TOKITO S ET AL: "HIGH-EFFICIENCY PHOSPHORESCENT POLYMER LIGHT-EMITTING DEVICES" ORGANIC ELECTRONICS, ELSEVIER, AMSTERDAM, NL, Bd. 4, Nr. 2/3, September 2003 (2003-09), Seiten 105-111, XP001177145 ISSN: 1566-1199
- COCCHI M ET AL: "HIGHLY EFFICIENT ORGANIC ELECTROPHOSPHORESCENT LIGHT-EMITTING DIODES WITH A REDUCED QUANTUM EFFICIENCY ROLL OFF AT LARGE CURRENT DENSITIES" APPLIED PHYSICS LETTERS, AMERICAN INSTITUTE OF PHYSICS. NEW YORK, US, Bd. 84, Nr. 7, 16. Februar 2004 (2004-02-16), Seiten 1052-1054, XP001197382 ISSN: 0003-6951
- SALBECK J ET AL: "Low molecular organic glasses for blue electroluminescence" SYNTHETIC METALS, ELSEVIER SEQUOIA, LAUSANNE, CH, Bd. 91, 1997, Seiten 209-215, XP002277588 ISSN: 0379-6779
- BALDO M A ET AL: "HIGHLY EFFICIENT PHOSPHORESCENT EMISSION FROM ORGANIC ELECTROLUMINESCENT DEVICES", NATURE: INTERNATIONAL WEEKLY JOURNAL OF SCIENCE, NATURE PUBLISHING GROUP, UNITED KINGDOM, vol. 395, no. 6698, 10 September 1998 (1998-09-10), pages 151-154, XP001002103, ISSN: 0028-0836, DOI: 10.1038/25954
- TANG C W ET AL: "Organic electroluminescent diodes", APPLIED PHYSICS LETTERS, AIP, AMERICAN INSTITUTE OF PHYSICS, MELVILLE, NY, US, vol. 51, no. 12, 21 September 1987 (1987-09-21), pages 913-915, XP002246527, ISSN: 0003-6951, DOI: 10.1063/1.98799
- H.C.F. Martens ET AL: "Frequency dependent carrier mobility in polymer LED's", Synthetic Metals, vol. 121, no. 1-3, 1 March 2001 (2001-03-01), pages 1643-1644, XP055053614, ISSN: 0379-6779, DOI: 10.1016/S0379-6779(00)00792-X
- Zhigang Li and Hong Meng: "Organic Light-Emitting Materials and Devices", 2002, Taylor & Francis ISBN: 978-1-57444-574-9 pages 10-19,
- A. Aurvey: "Organic Light-Emitting Devices", Springer ISBN: 0-387-95343-4 pages 53-55,

## Beschreibung

Die vorliegende Erfindung beschreibt ein neuartiges Designprinzip für organische Elektrolumineszenzelemente und dessen Verwendung in darauf basierenden Displays.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. Der Einsatz halbleitender organischer Verbindungen, die zur Emission von Licht im sichtbaren Spektralbereich befähigt sind, steht gerade am Anfang der Markteinführung, zum Beispiel in organischen Elektrolumineszenzvorrichtungen (OLED). Für einfache OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "organischem Display" belegen.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen eine bis zu vierfache Quanten-, Energie- und Leistungseffizienz möglich. Als wesentliche Bedingungen für die praktische Anwendung dieser Phosphoreszenz-Emitter sind hier insbesondere eine hohe operative Lebensdauer und eine niedrige Einsatz- und Betriebsspannung, verbunden mit einer hohen Leistungseffizienz, um mobile Applikationen zu ermöglichen, zu nennen.

Hier wurden in letzter Zeit deutliche Fortschritte erzielt. Jedoch gibt es immer noch erhebliche Probleme, die einer dringenden Verbesserung bedürfen: So ist der Aufbau dieser OLEDs durch die Vielzahl organischer Schichten komplex und aufwändig; eine Reduktion der Anzahl der Schichten wäre für die Produktion sehr wichtig, um die Zahl der Produktionsschritte zu verringern und damit die Kosten zu senken und die Produktionssicherheit zu erhöhen. Weiterhin ist das Prozessfenster beim bisherigen Deviceaufbau häufig zu klein, d. h. kleinere Schwankungen des Dotierungsgrads oder der Schichtdicke resultieren in großen Schwankungen der Emissionseigenschaften. Hier wäre es wünschenswert, ein größeres Prozessfenster zur Verfügung zu haben, um die Produktionssicherheit zu erhöhen.

Dies macht weitere Verbesserungen bei der Herstellung von OLEDs, insbesondere beim Schichtaufbau, notwendig.

Der allgemeine Aufbau organischer Elektrolumineszenzvorrichtungen auf Basis niedermolekularer Verbindungen ist beispielsweise in US 4,539,507 und US 5,151,629 beschrieben. Üblicherweise besteht eine solche Vorrichtung aus mehreren Schichten, die mittels Vakuummethoden oder Drucktechniken aufeinander aufgebracht werden. Für phosphoreszierende organische Elektrolumineszenzvorrichtungen sind diese Schichten im Einzelnen:
1. Trägerplatte = Substrat (üblicherweise Glas oder Kunststofffolie).
2. Transparente Anode (üblicherweise Indium-Zinn-Oxid, ITO).
3. Lochinjektions-Schicht (**H**ole Injection **L**ayer = HIL): z. B. auf der Basis von Kupferphthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole. **T**ransport **L**ayer = HTL): üblicherweise auf der Basis von Triarylamin-Derivaten, z.B. 4,4',4"-Tris(N-1-naphthyl-N-phenyl-amino)-triphenylamin (NaphDATA) als erste Schicht und N,N'-Di(naphth-1-yl-N,N'-diphenyl-benzidin (NPB) als zweite Schicht.
5. Eine oder mehrere Emissions-Schichten (**Em**ission **L**ayer = EML): üblicherweise aus mit Phosphoreszenzfarbstoffen, z. B. Tris(phenylpyridyl)-iridium (Ir(PPy)₃), dotierten Matrixmaterialien, wie z. B. 4,4'-Bis(carbazol-9-yl)-biphenyl (CBP).
6. Lochblockier-Schicht (**H**ole-**B**locking-**L**ayer = HBL): üblicherweise aus BCP (2,9-Dimethyl-4,7-diphenyl-1,10-phenanthrolin = Bathocuproin) oder Bis-(2-methyl-8-chinolinolato)-(4-phenylphenolato)-aluminium(III) (BAIq).
7. Elektronentransport-Schicht (**E**lectron **T**ransport-**L**ayer = ETL): meist auf Basis von Aluminium-tris-8-hydroxychinolinat (AlQ₃).
8. Elektroneninjektions-Schicht (**E**lectron **I**njection **L**ayer = EIL, auch Isolatorschicht = ISL genannt): dünne Schicht bestehend aus einem Material mit einer hohen Dielektrizitätskonstanten, wie z. B. LiF, Li₂O, BaF₂, MgO, NaF.
9. Kathode: in der Regel Metalle, Metallkombinationen oder Metalllegierungen mit niedriger Austrittsarbeit, z. B. Ca, Ba, Cs, Mg, Al, In, Mg/Ag.

Wie man sieht, werden bei Elektrolumineszenzvorrichtungen basierend auf niedermolekularen Verbindungen den einzelnen Schichten unterschiedliche Funktionen zugeordnet. Dieser Aufbau einer phosphoreszierenden OLED ist somit sehr aufwändig, da viele Schichten, die wiederum aus vielen verschiedenen Materialien bestehen, nacheinarider aufgebracht werden müssen, was den Herstellungsprozess solcher OLEDs technisch sehr kompliziert macht.

Bislang gab es mehrere Ansätze, den Schichtaufbau von phosphoreszierenden OLEDs zu vereinfachen:
- In US 2003/0146443 werden OLEDs beschrieben, bei denen die Emissionsschicht (EML) aus einem Matrixmaterial mit elektronenleitenden Eigenschaften besteht, das mit einem phosphoreszierenden Emitter dotiert ist. Dabei vereinfacht sich der Schichtaufbau, da keine separate Elektronentransportschicht verwendet werden muss. Eine Lochtransportschicht ist gemäß dieser Anmeldung jedoch zwangsläufig notwendig. Diese OLEDs erreichen allerdings nicht die gleiche Effizienz wie herkömmlich aufgebaute OLEDs, d. h. unter Verwendung einer HBL/ETL.
- In den nicht offen gelegten Anmeldungen DE 10355358.4 und DE 10355380.0 wurde für bestimmte Matrixmaterialien beschrieben, dass niedrigere Spannungen und höhere Leistungseffizienzen erhalten werden, wenn keine separate Lochblockierschicht und/oder Elektronentransportschicht verwendet wird. Hier gehen also verbesserte elektronische Eigenschaften mit einer deutlich vereinfachten Device-Struktur einher. Jedoch wurden auch hier in allen Beispielen Lochtransportschichten auf Basis von Triarylaminen verwendet.

Durch das Weglassen von Schichten auf Kathodenseite konnte der Deviceaufbau also bereits vereinfacht werden. Für die technische Anwendung wäre es jedoch wünschenswert, den Schichtaufbau in der Elektrolumineszenzvorrichtung noch weiter vereinfachen zu können, ohne dass sich dabei die elektronischen Eigenschaften im Device verschlechtern.

Überraschend wurde nun gefunden, dass ein Triplett-Device, in dem die Emissionsschicht direkt an die Lochinjektionsschicht oder an die Anode, also an eine elektrisch leitfähige Schicht, angrenzt, weiterhin sehr gute elektronische Eigenschaften bei einem gleichzeitig weiter vereinfachten Schichtaufbau zeigt. Dies ist ein überraschendes Ergebnis, da die Fachwelt bislang immer davon ausgegangen war, dass eine oder mehrere Lochtransportschichten zwischen der Emissionsschicht und der Lochinjektionsschicht bzw. der Anode zwingend notwendig für die gute Funktion einer phosphoreszierenden Elektrolumineszenzvorrichtung ist. So wurde bereits in den ersten Patenten zu Triplett-Devices (z. B. US 6,303,238) eine Lochtransportschicht auf Basis von Triarylaminderivaten verwendet und in der ersten Veröffentlichung eines Triplett-Devices (M. A. Baldo et al., Nature 1998, 395, 151) ein Device-Aufbau beschrieben, in dem Kupferphthalocyanin als Lochinjektionsschicht und NPB als Lochtransportschicht verwendet werden.

Gegenstand der Erfindung ist daher eine organische Elektrolumineszenzvorrichtung gemäß Anspruch 1

Unter einer Lochinjektionsschicht im Sinne dieser Erfindung soll eine organische oder metallorganische Schicht im direkten Kontakt mit der Anode verstanden werden, die freie Ladungsträger enthält und intrinsisch elektrisch leitfähig ist. Beim Löchinjektionsmaterial, welches niedermolekular, dendritisch, oligomer oder polymer sein kann, handelt es sich also um einen (organischen) elektrischen Leiter, der im Idealfall Ohm'sches Verhalten zeigt, bei dem also der Strom proportional zur angelegten Spannung ist. Die Lochinjektionsschicht ist im Allgemeinen aus dotierten organischen Verbindungen aufgebaut; jedoch gibt es auch andere Verbindungen, die diese Anforderungen erfüllen.

Weil die Abgrenzung zwischen einer Lochinjektionsschicht und einer Lochtransportschicht nicht immer ganz eindeutig ist, sollen im Sinne dieser Erfindung insbesondere folgende Definitionen gelten: Schichten im direkten Kontakt zur Anode, deren elektrische Leitfähigkeit größer als 10⁻⁸ S/cm ist, bevorzugt zwischen 10⁻⁷ und 10⁻¹ S/cm, besonders bevorzugt zwischen 10⁻⁶ und 10⁻² S/cm, werden im Sinne dieser Erfindung als Lochinjektionsschichten bezeichnet. Dabei kann die Messung der Leitfähigkeit in diesem Leitfähigkeitsbereich durch Zweipunkt-Messung am Film durchgeführt werden, wobei der Ohm'sche Widerstand gemessen wird und daraus wiederum, unter Berücksichtigung der Schichtdicke und der Länge, der spezifische Widerstand und die Leitfähigkeit bestimmt werden (D. Meschede, Gerthsen, Physik, 21. Auflage, 2001, Seite 319). Ausführungsbeispiele dieser Schichten sind dotierte leitfähige Polymere, insbesondere dotierte Polythiophen- oder Polyanilinderivate, die direkt an die Anode angrenzen. Weitere Beispiele für Lochinjektionsschichten sind solche, die aus dotierten Triarylaminderivaten, die niedermolekular, oligomer, dendritisch oder polymer sein können, aufgebaut sind und direkt an die Anode angrenzen, wobei die Dotierung des Triarylaminderivats beispielsweise oxidativ durch ein Oxidationsmittel und/oder durch eine Säure und/oder Lewis-Säure erfolgen kann. Ebenso werden im Sinne dieser Erfindung Schichten, die aus Metallphthalocyaninen, wie beispielsweise Kupferphthalocyanin (CuPc), aufgebaut sind und direkt an die Anode angrenzen, als Lochinjektionsschicht bezeichnet (auch wenn hier der Mechanismus der Leitfähigkeit nicht ganz eindeutig ist und möglicherweise, ohne an eine bestimmte Theorie gebunden sein zu wollen, durch eine hohe Photoleitfähigkeit bei Betrieb der OLED zustande kommt).

Unter einer Lochtransportschicht soll dagegen eine Schicht verstanden werden, die zunächst keine freien Ladungsträger enthält und daher keine elektrische Leitfähigkeit zeigt. Bei Lochtransportmateriallen handelt es sich also um organische Halbleiter, die typisches Halbleiter- bzw. Diodenverhalten zeigen. Diese sind im Allgemeinen aus undotierten organischen Verbindungen aufgebaut, meist aus Triarylaminderivaten, die niedermolekular, oligomer, dendritisch oder polymer sein können, wie beispielsweise NaphDATA oder NPB. Die Lochtransportschicht liegt entweder zwischen der Emissionsschicht und der Lochinjektionsschicht oder zwischen der Emissionsschicht und der Anode, wobei bei Verwendung mehrerer Schichten, die diese Eigenschaften aufweisen, alle diese Schichten als Lochtransportschichten bezeichnet werden.

Im Sinne dieser Anmeldung sind keine polymeren organischen Leuchtdioden (PLEDs) gemeint, da dort im Allgemeinen das Polymer selbst schon mehrere Aufgaben, wie Ladungstransport und Emission, erfüllt und deshalb in der Regel hier nur Einschicht- oder Zweischichtdevices (die dann noch eine zusätzliche Ladungsinjektionsschicht enthalten) erzeugt werden. Unter polymeren organischen Leuchtdioden im Sinne dieser Anmeldung sollen organische Leuchtdioden verstanden werden, bei denen die Emissionsschicht aus einem Polymer, einer Mischung mehrerer Polymere oder einer Mischung eines oder mehrerer Polymere mit einer oder mehreren niedermolekularen Verbindungen besteht, wobei das Polymer im Allgemeinen ein Molekulargewicht M_{w} von mehr als 5000 g/mol, meist mehr als 10000 g/mol aufweist und dadurch charakterisiert ist, dass es sich um Molekulargewichtsverteilungen handelt.

In einer bevorzugten Ausführungsform der Erfindung handelt es sich also um eine organische Elektrolumineszenzvorrichtung, in der entweder das Matrixmaterial oder der phosphoreszierende Emitter eine niedermolekulare definierte Verbindung mit einem Molekulargewicht von kleiner als 10000 g/mol, bevorzugt kleiner als 5000 g/mol, besonders bevorzugt kleiner als 3000 g/mol. Besonders bevorzugt sind sowohl das Matrixmaterial wie auch der phosphoreszierende Emitter niedermolekulare definierte Verbindungen mit einem Molekulargewicht von kleiner als 10000 g/mol, bevorzugt kleiner als 5000 g/mol, besonders bevorzugt kleiner als 3000 g/mol.

Die organische Elektrolumineszenzvorrichtung kann außer den oben genannten Schichten noch weitere Schichten, wie beispielsweise eine oder mehrere Lochblockier- (HBL) und/oder Elektronentransport- (ETL) und/oder Elektroneninjektionsschichten (EIL) enthalten. Es sei aber darauf hingewiesen, dass die Elektrolumineszenzvorrichtung auch bei Abwesenheit dieser Schichten sehr gute Ergebnisse liefert und dass es somit wegen des vereinfachten Schichtaufbaus bevorzugt ist, wenn die Elektrolumineszenzvorrichtung diese Schichten nicht enthält. In einer bevorzugten Ausführungsform der Erfindung grenzt die Emissionsschicht direkt an die Elektronentransportschicht, d. h. die erfindungsgemäße Elektrolumineszenzvorrichtung enthält keine Lochblockierschicht (HBL).

In einer weiteren bevorzugten Ausführungsform der Erfindung grenzt die Emissionsschicht direkt an die Kathode bzw. an die Elektroneninjektionsschicht, d. h. die erfindungsgemäße Elektrolumineszenzvorrichtung enthält keine Lochblockierschicht (HBL) und keine Elektronentransportschicht (ETL).

Es kann auch mehr als eine Emissionsschicht vorhanden sein. Zwei oder mehr Emissionsschichten sind besonders für weiß emittierende Elektrolumineszenzvorrichtungen geeignet. Dabei muss mindestens eine der Emissionsschichten elektrophosphoreszierend sein. Weiterhin können die Emissionsschichten mit denselben oder mit unterschiedlichen Matrixmaterialien aufgebaut sein. Aus Gründen der Kontaminationsgefahr und der Ressourcenschonung hat es sich jedoch als vorteilhaft erwiesen, wenn in mehreren oder allen Emissionsschichten die gleichen Matrixmaterialien verwendet werden.

Bevorzugt ist eine organische Elektrolumineszenzvorrichtung dadurch gekennzeichnet, dass die Schichtdicke der Emissionsschicht eine Dicke von 1 bis 300 nm aufweist, besonders bevorzugt von 5 bis 200 nm, ganz besonders bevorzugt 10 bis 150 nm.

Weiterhin bevorzugt ist eine organische Elektrolumineszenzvorrichtung dadurch gekennzeichnet, dass als phosphoreszierender Emitter eine Verbindung enthalten ist, die mindestens ein Atom der Ordnungszahl größer 36 und kleiner 84 aufweist. Besonders bevorzugt ist eine organische Elektrolumineszenzvorrichtung dadurch gekennzeichnet, dass der phosphoreszierende Emitter mindestens ein Element der Ordnungszahl größer 56 und kleiner 80, ganz besonders bevorzugt Molybdän, Wolfram, Rhenium, Ruthenium, Osmium, Rhodium, fridium, Palladium, Platin, Silber, Gold oder Europium enthält, ganz besonders bevorzugt Iridium oder Platin, beispielsweise gemäß den Patentanmeldungen WO 98/01011, US 02/0034656, US 03/0022019, WO 00/70655, WO 01/41512, WO 02/02714, WO 02/15645, EP 1191613, EP 1191612, EP 1191614, WO 03/040257, WO 03/084972, WO 03/099959, WO 03/040160, WO 02/081488, WO 02/068435, WO 04/026886, WO 04/081017 und DE 10345572.8. Diese werden via Zitat als Bestandteil der Anmeldung erachtet.

Der Dotierungsgrad des phosphoreszierenden Emitters in der Matrix beträgt 0.5 bis 50 %, bevorzugt 1 bis 40 %, besonders bevorzugt 3 bis 30 %, ganz besonders bevorzugt 5 bis 25 %. Dabei wurde überraschend gefunden, dass kleinere Schwankungen im Dotierungsgrad keinen Einfluss auf die elektrischen und optischen Eigenschaften haben.

Bevorzugt ist eine organische Elektrolumineszenzvorrichtung dadurch gekennzeichnet, dass die Glastemperatur T_{g} des Matrixmaterials größer als 100 °C, besonders bevorzugt größer 120 °C, ganz besonders bevorzugt größer 140 °C ist. Damit die Materialien während der Sublimation und während des Aufdampfprozesses stabil sind, ist es bevorzugt, wenn sie eine hohe thermische Stabilität aufweisen, bevorzugt größer 200 °C, besonders bevorzugt größer 300 °C, ganz besonders bevorzugt größer 350 °C.

Bevorzugt ist eine organische Elektrolumineszenzvorrichtung dadurch gekennzeichnet, dass das Matrixmaterial im sichtbaren Spektralbereich zwischen 380 nm und 750 nm bei einer Filmdicke von 30 nm eine Extinktion kleiner 0.2, bevorzugt kleiner 0.1, besonders bevorzugt kleiner 0.05, aufweist.

Die niedrigste Triplettenergie der Matrixmaterialien liegt bevorzugt zwischen 2 und 4 eV. Dabei ist die niedrigste Triplettenergie definiert als die Energiedifferenz zwischen dem Singulett-Grundzustand und dem niedrigsten Triplettzustand des Moleküls. Die Bestimmung der Triplettenergie kann durch spektroskopische Methoden oder durch quantenchemische Rechnung erfolgen. Diese Triplettlage hat sich als günstig erwiesen, da dann der Energieübertrag des Matrixmaterials auf den Triplettemitter sehr effizient ablaufen und somit zu hoher Effizienz der Emission aus dem Triplettemitter führen kann. Bevorzugt sind Matrixmaterialien, deren Triplettenergie größer ist als die Triplettenergie des verwendeten Triplettemitters. Bevorzugt ist die Triplettenergie des Matrixmaterials um mindestens 0.1 eV größer als die des Triplettemitters, insbesondere um mindestens 0.5 eV größer als die des Triplettemitters.

Bevorzugt handelt es sich bei dem Matrixmaterial und beim phosphoreszierenden Emitter um ungeladene Verbindungen. Diese sind gegenüber Salzen bevorzugt, da sie sich im Allgemeinen leichter bzw. bei geringerer Temperatur verdampfen lassen als geladene Verbindungen, die ionische Kristallgitter bilden. Außerdem neigen Salze verstärkt zur Kristallisation, was der Bildung glasartiger Phasen entgegensteht. Weiterhin handelt es sich bei dem Matrixmaterial und bei dem phosphoreszierenden Emitter bevorzugt um definierte molekulare Verbindungen.

Es hat sich überraschend gezeigt, dass insbesondere die Verwendung elektronenleitender Matrixmaterialien ohne separate Lochtransportschicht gute Ergebnisse zeigt. Bevorzugt ist das Matrixmaterial daher eine elektronenleitende Verbindung, also eine Verbindung, die sich leicht reduzieren lässt.

Besonders bevorzugt sind Matrixmaterialien, die bei Reduktion überwiegend stabil sind, d. h. überwiegend reversible Reduktion zeigen bzw. überwiegend stabile Radikalanionen bilden. Dabei bedeutet "stabil" bzw. "reversibel", dass die Materialien bei Reduktion wenig oder keine Zersetzung bzw. chemische Reaktionen, wie Umlagerungen, zeigen. Dies lässt sich beispielsweise durch Lösungselektrochemie, insbesondere Cyclovoltammetrie, überprüfen.

Bevorzugt hat der phosphoreszierende Emitter ein höheres (weniger negatives) HOMO (höchstes besetztes Molekülorbital) als das Matrixmaterial und ist damit hauptsächlich für den Lochstrom in der OLED verantwortlich. Hierbei ist es bevorzugt, wenn das HOMO des phosphoreszierenden Emitters im Bereich von ± 0.5 eV gegenüber dem HOMO der Lochinjektionsschicht bzw. der Anode (je nachdem, ob eine Lochinjektionsschicht vorhanden ist oder nicht) liegt.

Bevorzugt hat das Matrixmaterial ein niedrigeres (negativeres) LUMO (niedrigstes unbesetztes Molekülorbital) als der phosphoreszierende Emitter und ist damit hauptsächlich für den Elektronenstrom in der OLED verantwortlich. Hierbei ist es bevorzugt, wenn das LUMO des Matrixmaterials im Bereich von ± 0.5 eV gegenüber dem LUMO der Lochblockierschicht bzw. der Elektronentransportschicht bzw. der Austrittsarbeit der Kathode (je nachdem, welche dieser Schichten direkt an die Emissionsschicht angrenzt) liegt.

Die Lage des HOMOs bzw. des LUMOs lässt sich durch unterschiedliche Methoden experimentell bestimmen, beispielsweise durch Lösungselektrochemie, z. B. Cyclovoltammetrie, oder durch UV-Photoelektronenspektroskopie. Außerdem lässt sich die Lage des LUMOs berechnen aus dem elektrochemisch bestimmten HOMO und dem optisch durch Absorptionsspektroskopie bestimmten Bandabstand. Auch die quantenchemische Berechnung der HOMO- und LUMO-Lagen ist möglich.

Die Elektronenbeweglichkeit des Matrixmaterials liegt bevorzugt zwischen 10⁻¹⁰ und 1 cm²/V·s, besonders bevorzugt zwischen 10⁻⁸ und 10⁻¹ cm²/V·S, ganz besonders bevorzugt zwischen 10⁻⁶ und 10⁻² cd²/ V.s unter den in der OLED gegebenen Feldstärken von 10⁴ bis 10⁶ V/cm. Dabei kann die Elektronenbeweglichkeit beispielsweise durch TOF (time of flight) Messungen bestimmt werden (L. B. Schein, A. Rosenberg, S. L. Rice, J. Appl. Phys. 1986, 60, 4287; J. X. Mack, L. B. Schein, A. Peled, Phys. Rev. B 1989, 39, 7500; A. R. Melnyk D. M. Pai: Physical Methods of Chemistry, Vol. 8, Eds. B. W. Rossiter, R. C. Baetzold, Wiley, New York, 1993; 2nd ed.).

Bevorzugte geeignete Matrixmaterialien, die ohne Lochtransportschicht und gegebenenfalls ohne Lochinjektionsschicht eingesetzt werden können und gute Ergebnisse liefern, sind Ketone, Imine, Phosphinoxide, Phosphinsulfide, Phosphinselenide, Phosphazene, Sulfone und Sulfoxide gemäß den Formeln (1) bis (4), 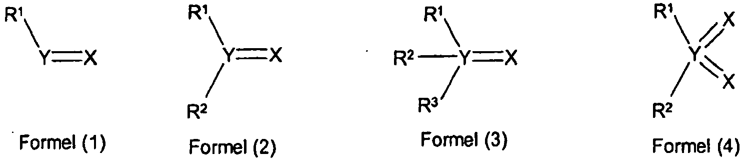 wobei die verwendeten Symbole folgende Bedeutung haben:
- Y: ist gleich C in Formel (2) und P, As, Sb, Bi in den Formeln (1) und (3) und S, Se, Te, in Formeln (1), (2) und (4);
- X: ist bei jedem Auftreten gleich oder verschieden NR⁴, O, S, Se, Te;
- R¹, R², R³: ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁵ substituiert oder auch unsubstituiert sein kann, wobei ein oder mehrere nicht benachbarte CH₂-Gruppen durch -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶-: oder -CONR⁶- ersetzt sein können und wobei ein oder mehrere H-Atome durch F, Cl, Br, I, CN oder NO₂ ersetzt sein können, oder ein aromatisches oder heteroaromatisches Ringsystem oder eine Aryloxy- oder Heteroaryloxygruppe mit 1 bis 40 aromatischen C-Atomen, die durch einen oder mehrere Reste R⁵ substituiert sein können, wobei mehrere Substituenten R¹, R² und/oder R³ miteinander ein mono- oder polycyclische, aliphatisches oder aromatisches Ringsystem bilden können;
- R⁴: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -R⁶C=CR⁶-, -C≡C-, Si(R⁶)₂, Ge(R⁶)₂, Sn(R⁶)₂, -NR⁶-, -O-, -S-, -CO-O- oder -O-CO-O- ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R⁶ substituiert sein kann, oder OH oder N(R⁵)₂;
- R⁵: ist bei jedem Auftreten gleich oder verschieden R⁴ oder CN, B(R⁶)₂ oder Si(R⁶)₃;
- R⁶: ist bei jedem Auftreten gleich oder verschieden H oder ein aliphatischer oder aromatischer Kohlenwasserstoffrest mit 1 bis 20 C-Atomen;
mit der Maßgabe, dass das Molekulargewicht mindestens 150 g/mol beträgt.

Unter einem aromatischen bzw. heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nichtaromatische Einheit (< 10 % der von H verschiedenen Atome, bevorzugt < 5 % der von H verschiedenen Atome), wie beispielsweise sp³-hybridisierter C, O, N, etc., unterbrochen sein können. So sollen also beispielsweise auch Systeme wie 9,9'-Spirobifluoren, 9,9-Diarylfluoren, Triarylamin, Diphenylether, etc. als aromatische Systeme verstanden werden.

Ketone und Imine als Matrixmaterialien sind beispielsweise in der nicht offen gelegten Patentanmeldung WO 04/093207 beschrieben. Phosphine, Phosphinsulfide, Phosphinselenide, Phosphazene, Sulfone und Sulfoxide als Matrixmaterialien sind beispielsweise in der nicht offen gelegten Patentanmeldung DE 10330761.3 beschrieben. Bevorzugte Substituenten R¹ bis R³ sind aromatische oder heteroaromatische Ringsysteme; bevorzugte Substituenten R¹ bis R³ und bevorzugte Strukturen können den oben genannten Anmeldungen entnommen werden. Besonders bevorzugt sind Ketone, Phosphinoxide und Sulfoxide; ganz besonders bevorzugt sind Ketone.

Weiterhin bevorzugt ist eine organische Elektrolumineszenzvorrichtung dadurch gekennzeichnet, dass eine oder mehrere Schichten mit einem Sublimationsverfahren beschichtet werden. Dabei werden die niedermolekularen Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft. Bevorzugt ist ebenfalls eine organische Elektrolumineszenzvorrichtung dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die niedermolekularen Materialien in einem interten Trägergas bei einem Druck zwischen 10⁻⁵ mbar und 1 bar aufgebracht.

Weiterhin bevorzugt ist eine organische Elektrolumineszenzvorrichtung dadurch gekennzeichnet, dass eine oder mehrere Schichten mit dem LITI-Verfahren (Light Induced Thermal Imaging, Thermotransferdruck) beschichtet werden.

Die oben beschriebenen emittierenden Vorrichtungen weisen nun folgende überraschende Vorteile gegenüber dem Stand der Technik auf:
1. Die Effizienz entsprechender Vorrichtungen ist vergleichbar oder höher als bei Systemen, die separate Lochtransportschichten enthalten. Dies ist ein überraschendes Ergebnis, da man bislang immer davon ausgegangen war, dass für eine gute Funktion der Elektrolumineszenzvorrichtung die Verwendung ein oder mehrerer Lochtransportschichten zwingend notwendig ist.
2. Die Betriebsspannungen sind vergleichbar Elektrolumineszenzvorrichtungen, die eine separate Lochtransportschicht enthalten.
3. Die Schichtaufbau ist einfacher, weil mindestens eine organische Schicht weniger verwendet wird als in Elektrolumineszenzvorrichtungen gemäß dem Stand der Technik. Ein besonders deutlicher Vorteil ist gegeben, wenn die Emissionsschicht nicht nur direkt an die Lochinjektionsschicht bzw. an die Anode grenzt, sondern auch direkt an die Kathode grenzt, weil dann die gesamte Elektrolumineszenzvorrichtung nur aus ein oder zwei organischen Schichten (Emissionsschicht und gegebenenfalls Lochinjektionsschicht) besteht. Der Produktionsaufwand wird dadurch deutlich geringer. Dies ist ein erheblicher Vorteil im Produktionsprozess, da bei der herkömmlichen Herstellungsweise im Allgemeinen für jede organische Schicht eine separate Aufdampfanlage verwendet wird, wodurch mindestens eine derartige Anlage somit eingespart werden kann bzw. komplett entfällt. Dies schont die Ressourcen und mindert das Kontaminationsrisiko, wodurch die Ausbeute steigt.
4. Das Emissionsspektrum ist identisch zum Emissionsspektrum, das mit einer vergleichbaren Elektrolumineszenzvorrichtung erhalten wird, die eine Lochtransportschicht enthält. Insbesondere beobachtet man, dass die Emissionseigenschaften, beispielsweise die Emissionsfarbe, in einem weiten Bereich unabhängig vom Dotierungsgrad.sind. Dies ist ein klarer Vorteil in der Produktion, da dadurch das Prozessfenster erweitert wird und kleinere Abweichungen bei den Herstellbedingungen nicht zu Abweichungen der Produkteigenschaften führen. Dadurch wird die Produktionssicherheit erhöht.
5. Ebenso sind die Deviceeigenschaften, wie Emissionsfarbe und Spannung, relativ unabhängig von der Schichtdicke der Emissionsschicht. Dies ist ebenfalls ein deutlicher Vorteil in der Produktion, da dadurch das Prozessfenster erweitert wird und kleinere Abweichungen bei den Herstellbedingungen nicht zu Abweichungen der Produkteigenschaften führen. Dadurch wird die Produktionssicherheit erhöht.
6. Die Lebensdauer entsprechender Vorrichtungen ist vergleichbar zu Systemen, die separate Lochtransportschichten enthalten.

Details zu den hier gemachten Angaben finden sich in den unten beschriebenen Beispielen.

Im vorliegende Anmeldetext und auch in den weiteren folgenden Beispielen wird nur auf organische Leuchtdioden und die entsprechenden Displays abgezielt. Trotz dieser Beschränkung der Beschreibung ist es für den Fachmann ohne weiteres erfinderische Zutun möglich, das entsprechende erfindungsgemäße Design auch für andere, verwandte Vorrichtungen, z. B. für organische Solarzellen (O-SCs), organische Laserdioden (O-Laser) oder auch photorefraktive Bauteile, um nur einige weitere Anwendungen zu nennen, zu verwenden.

### Beispiele:

### Herstellung und Charakterisierung von organischen Elektrolumineszenzvorrichtungen:

Erfindungsgemäße Elektrolumineszenzvorrichtungen können, wie beispielsweise in der Patentanmeldung DE10330761.3 beschrieben, dargestellt werden. Dieses Verfahren wurde im Einzelfall auf die jeweiligen Gegebenheiten (z. B. Schichtdickenvariation) angepasst. Für die Herstellung der erfindungsgemäßen Vorrichtungen wurde keine separate Lochtransportschicht verwendet, außerdem ebenfalls keine Elektronentransportschicht und keine Lochblockierschicht.

In den folgenden Beispielen werden die Ergebnisse verschiedener OLEDs vorgestellt. Der grundlegende Aufbau, wie die verwendeten Materialien und Schichtdicken, waren zur besseren Vergleichbarkeit identisch:

Analog dem o. g. allgemeinen Verfahren wurden emittierende OLEDs mit folgendem Aufbau erzeugt:

| | |
|---|---|
| PEDOT (HIL) | 60 nm (aus Wasser aufgeschleudert; PEDOT bezogen von H. C. Starck; Poly-[3,4-ethylendioxy-2,5-thiophen] mit Poly(styrolsulfonsäure)) |
| Emissionsschicht: | genauer Aufbau: siehe Beispiele in Tabelle 1 |
| Ba-Al (Kathode) | 3 nm Ba, darauf 150 nm Al |

In keinem der Beispiele wurde eine separate Lochblockierschicht und eine separate Elektronentransportschicht verwendet.

Außerdem wurden zum Vergleich Elektrolumineszenzvorrichtungen erzeugt, die zwischen der Emissionsschicht und der Lochinjektionsschicht eine Lochtransportschicht gemäß dem Stand der Technik enthielten, die folgendermaßen aufgebaut war:

| | |
|---|---|
| NaphDATA (HTM) | 20 nm (aufgedampft; NaphDATA bezogen von SynTec; 4,4',4"-Tris(N-1-naphthyl-N-phenyl-amino)-triphenylamin |
| S-TAD (HTM) | 20 nm (aufgedampft; S-TAD hergestellt nach WO 99/12888; 2,2',7,7'-Tetrakis(diphenylamino)-spirobifluoren) |

Diese noch nicht optimierten OLEDs wurden standardmäßig charakterisiert; hierfür wurden die Elektrolumineszenzspektren, die maximale Effizienz (gemessen in cd/A) und die maximale Leistungseffizienz (gemessen in Im/W) in Abhängigkeit der Helligkeit, berechnet aus Strom-Spannungs-Helligkeits-Kennlinien (IUL-Kennlinien), bestimmt.

In Tabelle 1 sind die Ergebnisse verschiedener Beispiele zusämmengefasst. Die Zusammensetzung der Emissionsschicht inklusive der Schichtdicken ist aufgeführt. Die dotierten phosphoreszierenden Emissionsschichten enthalten als Matrixmaterial **M1** die Verbindung Bis(9,9'-spiro-bifluoren-2-yl)keton (synthetisiert gemäß WO 04/093207). Die Lebensdauern der verschiedenen Device-Anordnungen sind dabei vergleichbar. Die Synthese von Ir(piq)₃ erfolgte gemäß US 2003/0068526. Die Synthese von Ir-**1** erfolgte gemäß der nicht offen gelegten Anmeldung DE 10345572.8.

Die in der Tabelle 1 verwendeten Abkürzungen entsprechen den folgenden Verbindungen:

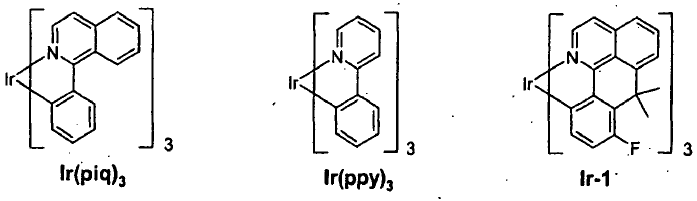

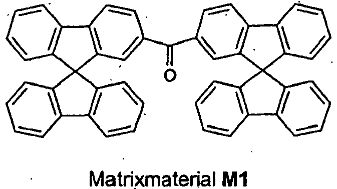

**Tabelle 1:**

| Experiment | HIL | HTL1 | HTL2 | EML | Max Effizienz (cd/A) | Max Leistungseffizienz (Im/W) | Spannung (V) bei 100 cd/m² |
|---|---|---|---|---|---|---|---|
| Beispiel 1 a) | PEDOT (60nm) | --- | --- | **M1 : Ir(piq)₃** (20%) (100nm) | 7.3 | 8.2 | 3.5 |
| Beispiel 1 b) (Vergleich) | PEDOT (60nm) | NaphDATA (20 nm) | S-TAD (20 nm) | **M1 : Ir(piq)₃** (20%) (60nm) | 7.0 | 8.1 | 3.2 |
| Beispiel 1 c) (Vergleich) | PEDOT (60nm) | --- | S-TAD (20 nm) | **M1 : Ir(piq)₃** (20%) (80nm) | 5.8 | 5.1 | 4.0 |
| Beispiel 2 a) | PEDOT (60nm) | --- | --- | **M1 : Ir(ppy)₃ (20%)** (80nm) | 40.1 | 50.4 | 3.0 |
| Beispiel 2 b) (Vergleich) | PEDOT (60nm) | NaphDATA (20 nm) | S-TAD (20 nm) | **M1 : Ir(ppy)₃** (20%) (60nm) | 35.3 | 49.8 | 3.0 |
| Beispiel 3 a) | PEDOT (60nm) | --- | --- | **M1**:Ir-1(10%) (60nm) | 14.8 | 11.4 | 3.8 |
| Beispiel 3 b) (Vergleich) | PEDOT (60nm) | NaphDATA (20 nm) | S-TAD (20 nm) | **M1 : Ir-1** (10%) (60nm) | 14.9 | 11.0 | 4.0 |

Zusammenfassend kann gesagt werden, dass OLEDs, gefertigt nach dem neuen Designprinzip, eine vergleichbare oder höhere Effizienz bei vergleichbaren Spannungen und vergleichbarer Lebensdauer aufweisen, wie man leicht aus Tabelle 1 entnehmen kann, wobei sich der Aufbau der OLED erheblich vereinfacht hat.

## Patentansprüche

1. Organische nicht polymeric Elektrolumineszenzvorrichtung, enthaltend eine Anode, eine Kathode und mindestens eine Emissionsschicht, enthaltend mindestens ein Matrixmaterial, welches mit mindestens einem phosphoreszierenden Emitter dotiert ist, **dadurch gekennzeichnet, dass** die Emissionsschicht auf Anodenseite direkt an eine elektrisch leitfähige Schicht angrenzt und dass sowohl das Matrixmaterial als auch der phosphoreszierende Emitter niedermolekulare definierte Verbindungen mit einem Molekulargewicht von kleiner als 10000 g/mol sind,
wobei die elektrisch leitfähige Schicht die Anode selbst oder eine im direkten kontakt mit des Anode stehende organische oder metallorganische Lochinjektionsschicht zwischen Anode und Emissionsschicht ist und wobei die Lochinjektionsschicht eine elektrische Leitfähigkeit von größer als 10⁻⁸ S/cm besitzt

2. Organische Elektrolumineszenzvorrichtung gemäß Anspruch 1, **dadurch gekennzeichnet, dass** sie weitere Schichten enthält, die ausgewählt sind aus einer oder mehreren Lochblockierschichten und/oder Elektronentransportschichten und/oder Elektroneninjektionsschichten.

3. Organische Elektrolumineszenzvorrichtung gemäß Anspruch 1 oder 2, **dadurch gekennzeichnet, dass** die Emissionsschicht ohne Verwendung einer Lochblockierschicht direkt an die Elektronentransportschicht, die Elektroneninjektionsschicht oder an die Kathode grenzt.

4. Organische Elektrolumineszenzvorrichtung gemäß einem oder mehreren der Ansprüche 1 bis 3, **dadurch gekennzeichnet, dass** mehr als eine Emissionsschicht vorhanden ist.

5. Organische Elektrolumineszenzvorrichtung gemäß einem oder mehreren der Ansprüche 1 bis 4, **dadurch gekennzeichnet, dass** als phosphoreszierender Emitter eine Verbindung enthalten ist, die mindestens ein Atom der Ordnungszahl größer 38 und kleiner 84 enthält.

6. Organische Elektrolumineszenzvorrichtung gemäß Anspruch 5, **dadurch gekennzeichnet, dass** der phosphoreszierende Emitter mindestens ein Element, ausgewählt aus Molybdän, Wolfram, Rhenium, Ruthenium, Osmium, Rhodium, Iridium, Palladium, Platin, Silber, Gold oder Europium, enthält.

7. Organische Elektrolumineszenzvorrichtung gemäß einem oder mehreren der Ansprüche 1 bis 6, **dadurch gekennzeichnet, dass** der Dotierungsgrad des phosphoreszierenden Emitters in der Matrix 0.5 bis 50 % beträgt

8. Organische Elektrolumineszenzvorrichtung gemäß einem oder mehreren der Ansprüche 1 bis 7, **dadurch gekennzeichnet, dass** das Matrixmaterial eine elektronenleitende Verbindung ist.

9. Organische Elektrolumineszenzvorrichtung gemäß einem oder mehreren der Ansprüche 1 bis 8, **dadurch gekennzeichnet, dass** das Matrixmaterial ausgewählt ist aus den Klassen der Ketone, Imine, Phosphinoxide, Phosphinsulfide, Phosphinselenide, Phosphazene, Sulfone und Sulfoxide, bevorzugt mit aromatischen Substituenten.

10. Organische Solarzelle, **dadurch gekennzeichnet, dass** der Aufbau einem oder mehreren der Ansprüche 1 bis 9 entspricht.

11. Organische Laserdiode, **dadurch gekennzeichnet, dass** der Aufbau einem oder mehreren der Ansprüche 1 bis 9 entspricht

## Claims

1. Organic non-polymeric electroluminescent device comprising an anode, a cathode and at least one emission layer comprising at least one matrix material which is doped with at least one phosphorescent emitter, **characterised in that** the emission layer is directly adjacent to an electrically conductive layer on the anode side and that both the matrix material and the phosphorescent emitter are low-molecular-weight defined compounds having a molecular weight of less than 10,000 g/mol,
where the electrically conductive layer is the anode itself or an organic or organometallic hole-injection layer between anode and emission layer which is in direct contact with the anode and where the hole-injection layer has an electrical conductivity of greater than 10⁻⁸ S/cm.

2. Organic electroluminescent device according to Claim 1, **characterised in that** it comprises further layers which are selected from one or more hole-blocking layers and/or electron-transport layers and/or electron-injection layers.

3. Organic electroluminescent device according to Claim 1 or 2, **characterised in that** the emission layer is directly adjacent to the electron-transport layer, the electron-injection layer or the cathode without the use of a hole-blocking layer.

4. Organic electroluminescent device according to one or more of Claims 1 to 3, **characterised in that** more than one emission layer is present.

5. Organic electroluminescent device according to one or more of Claims 1 to 4, **characterised in that** the phosphorescent emitter present is a compound which contains at least one atom having an atomic number of greater than 36 and less than 84.

6. Organic electroluminescent device according to Claim 5, **characterised in that** the phosphorescent emitter contains at least one element selected from molybdenum, tungsten, rhenium, ruthenium, osmium, rhodium, iridium, palladium, platinum, silver, gold or europium.

7. Organic electroluminescent device according to one or more of Claims 1 to 6, **characterised in that** the degree of doping of the phosphorescent emitter in the matrix is 0.5 to 50%.

8. Organic electroluminescent device according to one or more of Claims 1 to 7, **characterised in that** the matrix material is an electron-conducting compound.

9. Organic electroluminescent device according to one or more of Claims 1 to 8, **characterised in that** the matrix material is selected from the classes of the ketones, imines, phosphine oxides, phosphine sulfides, phosphine selenides, phosphazenes, sulfones and sulfoxides, preferably with aromatic substituents.

10. Organic solar cell, **characterised in that** the structure corresponds to one or more of Claims 1 to 9.

11. Organic laser diode, **characterised in that** the structure corresponds to one or more of Claims 1 to 9.

## Revendications

1. Dispositif électroluminescent non polymérique organique comprenant une anode, une cathode et au moins une couche d'émission comprenant au moins un matériau de matrice, lequel est dopé avec au moins un émetteur phosphorescent, **caractérisé en ce que** la couche d'émission est directement adjacente à une couche électriquement conductrice sur le côté d'anode et **en ce que** le matériau de matrice et l'émetteur phosphorescent sont tous deux des composés de poids moléculaire faible définis présentant un poids moléculaire inférieur à 10 000 g/mol,
où la couche électriquement conductrice est l'anode elle-même ou une couche d'injection de trous organique ou organométallique entre l'anode et la couche d'émission qui est en contact direct avec l'anode et où la couche d'injection de trous présente une conductivité électrique supérieure à 10⁻⁸ S/cm.

2. Dispositif électroluminescent organique selon la revendication 1, **caractérisé en ce qu'**il comprend d'autres couches qui sont choisies parmi une ou plusieurs couches de blocage de trous et/ou couches de transport d'électrons et/ou couches d'injection d'électrons.

3. Dispositif électroluminescent organique selon la revendication 1 ou 2, **caractérisé en ce que** la couche d'émission est directement adjacente à la couche de transport d'électrons, à la couche d'injection d'électrons ou à la cathode sans l'utilisation d'une couche de blocage de trous.

4. Dispositif électroluminescent organique selon une ou plusieurs des revendications 1 à 3, **caractérisé en ce que** plus d'une couche d'émission sont présentes.

5. Dispositif électroluminescent organique selon une ou plusieurs des revendications 1 à 4, **caractérisé en ce que** l'émetteur phosphorescent présent est un composé qui contient au moins un atome présentant un numéro atomique supérieur à 36 et inférieur à 84.

6. Dispositif électroluminescent organique selon la revendication 5, **caractérisé en ce que** l'émetteur phosphorescent contient au moins un élément choisi parmi molybdène, tungstène, rhénium, ruthénium, osmium, rhodium, iridium, palladium, platine, argent, or ou europium.

7. Dispositif électroluminescent organique selon une ou plusieurs des revendications 1 à 6, **caractérisé en ce que** le degré de dopage de l'émetteur phosphorescent dans la matrice est de 0,5 à 50%.

8. Dispositif électroluminescent organique selon une ou plusieurs des revendications 1 à 7, **caractérisé en ce que** le matériau de matrice est un composé conducteur d'électrons.

9. Dispositif électroluminescent organique selon une ou plusieurs des revendications 1 à 8, **caractérisé en ce que** le matériau de matrice est choisi parmi les classes des cétones, des imines, des oxydes de phosphine, des sulfures de phosphine, des séléniures de phosphine, des phosphazènes, des sulfones et des sulfoxydes, de façon préférable avec des substituants aromatiques.

10. Cellule laser organique, **caractérisée en ce que** la structure correspond à une ou plusieurs des revendications 1 à 9.

11. Diode laser organique, **caractérisée en ce que** la structure correspond à une ou plusieurs des revendications 1 à 9.
